# FASCICULE DE BREVET EUROPEEN

(11) **EP 3 668 286 B1**
(45) Date de publication et mention de la délivrance du brevet: **10.05.2023**
(21) Numéro de dépôt: 19209553.7
(22) Date de dépôt: 15.11.2019
(51) Int. Cl.: H05K 5/06

(54) **SYSTEME D'ETANCHEITE POUR UN EQUIPEMENT ELECTRIQUE**
ABDICHTSYSTEM FÜR ELEKTRISCHES GERÄT
SEALING SYSTEM FOR ELECTRICAL EQUIPMENT

(30) Priorité: 14.12.2018 FR 1872974
(43) Date de publication de la demande: 17.06.2020
(73) Titulaire: Valeo eAutomotive Germany GmbH, 91056 Erlangen (DE)
(72) Inventeur: LEDIEU, Cédric, 62144 MONT SAINT ELOI (FR); LABROSSE, Jean-Claude, 94220 CHARENTON LE PONT (FR)
(74) Mandataire: Valeo Powertrain Systems

(56) Documents cités:
- EP-A2- 1 883 147
- EP-B1- 2 856 568
- CA-A- 481 856
- CN-U- 206 992 854
- JP-A- 2005 045 904
- JP-A- 2012 075 253
- US-A1- 2005 026 489

## Description

### DOMAINE TECHNIQUE DE L'INVENTION

La présente invention concerne le domaine des équipements électriques, et plus particulièrement des machines électriques utilisées pour des véhicules.

L'invention vise notamment à permettre l'étanchéité d'un équipement électrique, notamment pour véhicule.

### ETAT DE LA TECHNIQUE

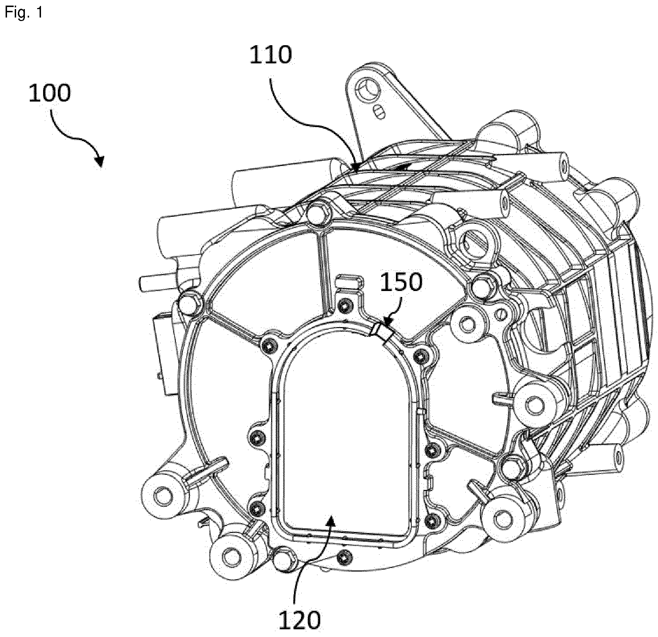

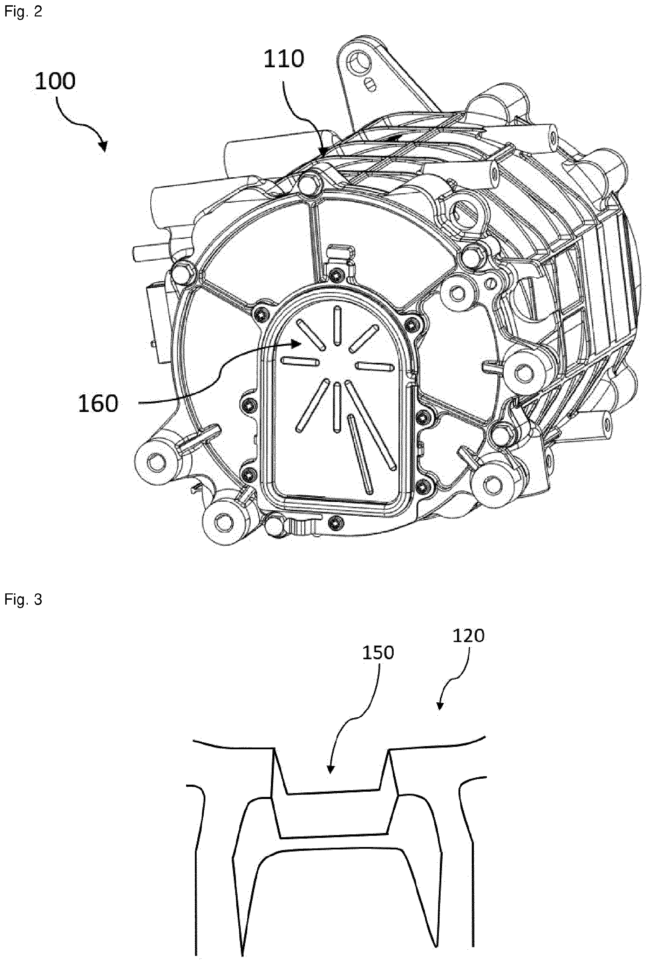

Les figures 1 et 2 représentent un équipement électrique 100 conforme à l'état de l'art. Un tel équipement électrique 100 comprend un châssis dans lequel est aménagée une cavité 110, par exemple cylindrique, comprenant la partie active de l'équipement électrique 100.

La cavité 110 est fermée par un couvercle 160. L'équipement électrique 100 comprend un palier 120, à l'interface entre l'extérieur et l'intérieur de la cavité 110. Ledit palier 120 comprend un logement, également fermé par le couvercle 160, ledit logement étant destiné à loger des capteurs reliés à l'intérieur de la cavité 110.

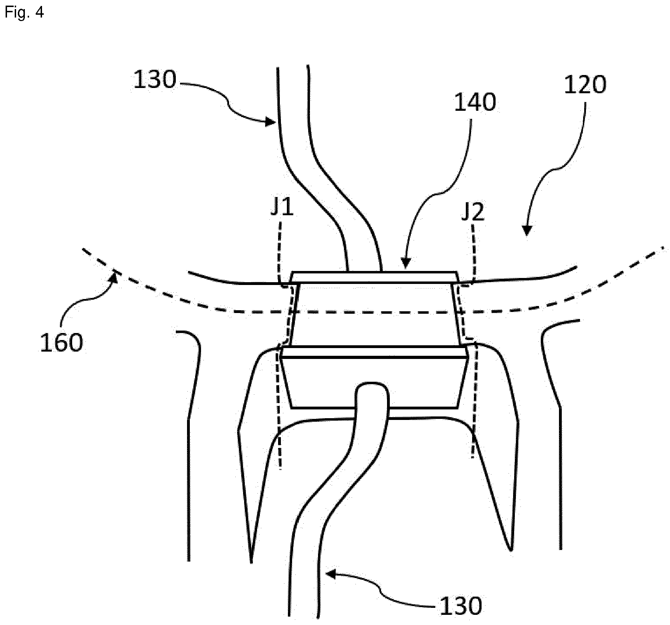

Toujours en référence aux figures 1, 2, 3, et 4, un câble 130 connecté à un capteur ou à un dispositif situé dans le logement ou à l'intérieur de la cavité 110, relie l'équipement électrique 100 à un deuxième équipement électrique. Ainsi, le câble 130 permet par exemple de transmettre à ce deuxième équipement électrique des informations mesurées par des capteurs présents dans le logement, concernant la partie active de l'équipement électrique 100.

Ces informations permettent par exemple de piloter plus efficacement l'équipement électrique 100 et/ou de détecter un dysfonctionnement relatif à cet équipement électrique 100.

De manière connue, le câble 130 doit notamment atteindre la cavité 110 et le logement aménagé dans le palier 120 afin de connecter les capteurs et le deuxième équipement électrique extérieur à ladite cavité 110. À cette fin, le câble 130 s'immisce entre ledit couvercle 160 et le palier 120.

Pour cela, en référence aux figures 1, 2 et 3, selon l'état de la technique, le câble 130 est inséré dans un joint 140 en caoutchouc, ledit joint 140 étant adapté pour ensuite être inséré et ajusté dans un passage 150 aménagé à la périphérie du palier 120. Ensuite, le couvercle 160, notamment muni de son propre joint, est fixé au palier 120 et recouvre le joint 140 inséré dans le passage 150. Le joint du couvercle 160 vient donc en appui contre le joint 140 prévu pour permettre le passage du câble 130 et ajusté dans le passage 150.

Le joint du couvercle 160 permet d'assurer l'étanchéité de la cavité 110 afin de protéger la partie active de l'équipement électrique 100. Cependant, dans le cas présent, le joint comprend une double jonction.

En effet, une première jonction J1 est située entre le palier 120 et le joint 140 et une deuxième jonction J2 est située entre le joint 140 et le palier 120.

Les éléments situés de chaque côté de la première jonction J1 et de la deuxième jonction J2 sont composés de matériaux différents. Il y a donc une différence de compression entre le joint du couvercle 160 et le palier 120 d'une part, où l'on a un contact entre une surface « dure » et une surface « souple » (celle du joint du couvercle 160) par rapport à la compression entre le joint du couvercle 160 et le joint 140, où l'on a un contact entre deux surfaces « souples ». Cette différence de compression peut engendrer des problèmes d'étanchéité dans la cavité 110, notamment à cause de ruissellements de liquide par capillarité le long d'au moins un câble 130 ou entre le joint 140 et le joint du couvercle 160.

Ceci représente un inconvénient majeur puisque la cavité 110 doit être impérativement étanche pour éviter tout risque de détérioration d'un élément de la partie active de l'équipement électrique 100.

Une autre solution possible à ce problème technique est notamment d'installer des connecteurs sur la paroi de la cavité 110, qui permettent d'assurer l'étanchéité de la cavité 110 lorsqu'au moins un câble 130 est installé dans ledit connecteur. Cependant, cette solution est très coûteuse, environ une dizaine d'euros par connecteur.

Le document JP 2012075253 A décrit un passage de câble étanche pour un équipement électrique mais il n'assure pas la fermeture étanche de l'équipement électrique en question. Parmi les autres documents de l'art antérieur connus, le document JP2005045904 décrit une structure de joint, le document US2005026489 décrit un système d'étanchéité de câble pour un connecteur et le document CA481856 décrit des organes de fermeture de dispositifs pour sceller les bouts de câbles électriques.

Il existe donc le besoin d'une solution économique permettant d'assurer l'étanchéité de la cavité lorsqu'un câble traverse ladite paroi.

### PRESENTATION DE L'INVENTION

L'invention est définie par les revendications indépendantes. Des modes de réalisation préférés sont définis par les revendications dépendantes.

### PRESENTATION DES FIGURES

L'invention sera mieux comprise à la lecture de la description qui va suivre, et se référant aux dessins annexés donnés à titre d'exemples dans lesquels des références identiques sont données à des objets semblables et sur lesquels :
Fig. 1 (déjà commentée) illustre un schéma d'un équipement électrique selon l'état de l'art ;
Fig. 2 (déjà commentée) illustre un schéma d'un équipement électrique selon l'état de l'art ;
Fig. 3 (déjà commentée) illustre schématiquement un passage aménagé à la périphérie d'un palier d'équipement électrique selon l'état de l'art ;
Fig. 4 (déjà commentée) illustre schématiquement un joint d'étanchéité placé dans un passage représenté à la figure 3 selon l'état de l'art ;
Fig. 5 représente le schéma d'un équipement électrique selon l'invention ;
Fig. 6 illustre un système d'étanchéité selon l'invention ;
Fig. 7 représente un équipement électrique et un système d'étanchéité selon un premier mode de réalisation de l'invention ;
Fig. 8 représente un équipement électrique et un système d'étanchéité selon le premier mode de réalisation de l'invention ;
Fig. 9 représente un équipement électrique et un système d'étanchéité selon un deuxième mode de réalisation de l'invention ;
Fig. 10 représente un équipement électrique et un système d'étanchéité selon un troisième mode de réalisation de l'invention.

Il faut noter que les figures exposent l'invention de manière détaillée pour mettre en oeuvre l'invention, lesdites figures pouvant bien entendu servir à mieux définir l'invention le cas échéant.

### DESCRIPTION DETAILLEE DE L'INVENTION

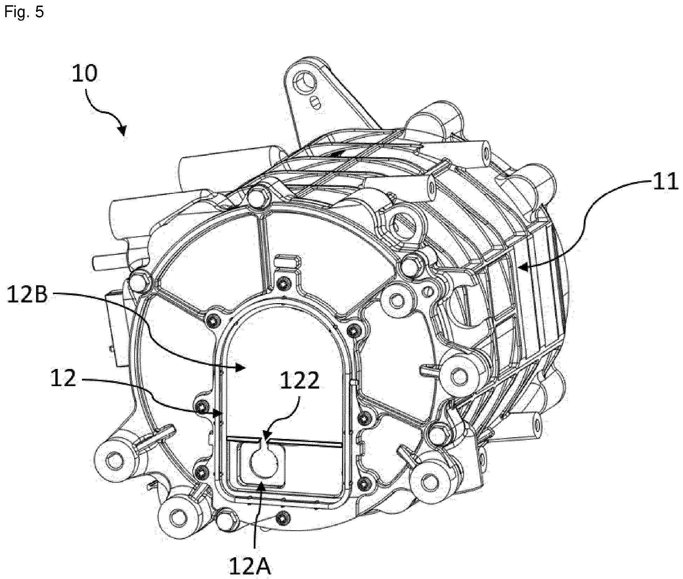

En référence à la figure 5, un équipement électrique 10 pour véhicule, présente un châssis dans lequel est aménagée une cavité 11, par exemple cylindrique, comprenant une partie active de l'équipement électrique 10. Par exemple, l'équipement électrique 10 est une machine électrique. Mais l'équipement électrique 10 peut être un onduleur, un convertisseur continucontinu ou un chargeur électrique.

La cavité 11 est délimitée par un palier 12. Un premier logement 12A et un deuxième logement 12B sont aménagés dans le palier 12. Un couvercle 16 est placé et fixé sur le palier 12 de façon à fermer lesdits logements 12A, 12B.

Ledit premier logement 12A permet de recevoir un système d'étanchéité 20 réalisant une connexion électrique étanche selon un exemple de l'invention. Ledit premier logement 12A peut être carré, comme représenté à la figure 5, ou de toute autre forme géométrique. De plus, une paroi périphérique dudit premier logement 12A peut présenter une encoche 122, configurée pour permettre le passage d'un ou plusieurs fils électriques associés au système d'étanchéité 20, de l'extérieur de l'équipement électrique 10 vers l'intérieur de l'équipement électrique 10 lors du montage du système d'étanchéité 20 dans l'équipement électrique 10, notamment dans le premier logement 12A.

Ledit deuxième logement 12B comprend des capteurs par exemple permettant de récupérer des informations caractérisant la partie active de l'équipement électrique 10. Par exemple, dans le cas d'un moteur, le deuxième logement 12B peut comprendre un capteur de position permettant de connaître la position du rotor par rapport au stator et un capteur de température mesurant la température à l'intérieur de la cavité 11 (non représentés).

Le couvercle 16 ferme l'équipement électrique 10, notamment le premier logement 12A et le deuxième logement 12B de manière étanche.

L'équipement électrique 10 comprend également un ou plusieurs fils électriques 13 pénétrant à l'intérieur de l'équipement électrique 10 au niveau du logement 12A du palier 12.

En effet, chaque fil électrique 13 est soit connecté entre la partie active et un autre équipement électrique extérieur à l'équipement électrique 10 via le premier logement 12A, soit connecté entre un capteur et un autre équipement électrique extérieur à l'équipement électrique 10, via le premier logement 12A. Ainsi, le fil électrique 13 permet l'échange de données entre l'équipement électrique 10 et d'autres équipements électriques et permet notamment, par exemple, de transmettre à ces autres équipements électriques des informations concernant la partie active de l'équipement électrique 10, mesurées par des capteurs, notamment présents dans le deuxième logement 12B. Ces informations permettent par exemple de piloter plus efficacement l'équipement électrique 10 et/ou de détecter un dysfonctionnement concernant cet équipement électrique 10.

Selon une forme de réalisation, l'équipement électrique 10 peut être une machine électrique tournante et l'équipement électrique extérieur peut être un onduleur permettant de piloter ladite machine électrique tournante.

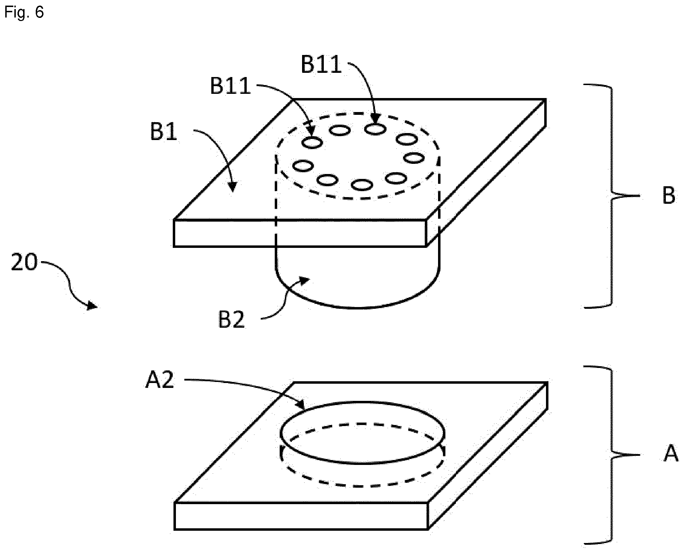

En référence à la figure 6, il est représenté une première forme de réalisation d'un système d'étanchéité 20 permettant d'assurer l'étanchéité d'un équipement électrique 10, comme présenté précédemment, notamment dans la zone du passage du fil électrique 13 de l'extérieur vers l'intérieur de l'équipement électrique 10.

Selon cette première forme de réalisation, ledit système d'étanchéité 20 comprend deux éléments distincts. Le système d'étanchéité comprend un socle A et un bouchon B.

Le socle A se présente comme une pièce rigide et peu souple, par exemple en plastique, de forme géométrique adaptée pour être insérée de façon ajustée dans le fond du premier logement 12A du palier 12. Selon l'exemple présenté en référence à la figure 6, le socle A est une pièce plastique de forme carrée. De plus, ledit socle A comprend un premier plateau A1 comprenant un orifice A2 traversant, par exemple cylindrique et positionné au centre du socle A. Tout le bord de l'orifice A2 traversant est continûment compris dans une face dudit premier plateau A1.

Toujours en référence à la figure 6, le bouchon B est une pièce constituée d'un matériau souple, par exemple une pièce en élastomère, le bouchon B présentant une souplesse supérieure à la souplesse du socle A. Ledit bouchon B comprend un deuxième plateau B1 dont les dimensions sont adaptées pour permettre l'insertion du bouchon B dans le premier logement 12A, notamment pour permettre ladite insertion, par exemple de telle sorte que le bouchon B comble l'intégralité du premier logement 12A.

Le deuxième plateau B1 comprend au moins un trou B11 traversant, comme représenté à la figure 6, le au moins un trou B11 est destiné à permettre le passage d'au moins un fil électrique 13.

Le deuxième plateau B1 peut comprendre plusieurs trous B11. Selon le mode de réalisation présenté, le nombre de trous B11 est égal au nombre de fils électriques 13. Les trous B11 du bouchon B ont une section transversale inférieure à la section transversale de chaque fil électrique 13 traversant le système d'étanchéité 20. Notamment, le diamètre de chaque trou B11 est inférieur au diamètre de chaque fil électrique 13. De cette façon, lorsqu'un fil électrique 13 est inséré dans un trou B11, aucun liquide ne peut ruisseler par capillarité le long de ce fil électrique 13 à travers ce trou B11. Une partie de l'étanchéité de la cavité 11 est donc assurée à la jonction entre chaque fil électrique 13 et chaque trou B11 associé audit fil électrique 13.

Le bouchon B comprend également une partie en saillie B2, dont la forme est adaptée pour que la partie en saillie B2 soit montée en force dans l'espace vide formé à l'intérieur de l'orifice A2 du socle A. Pour assurer cette montée en force, les dimensions de la partie en saillie B2 sont égales ou supérieures à celles de l'orifice A2. Ainsi, la partie en saillie B2 du bouchon B s'insère, à la manière d'un bouchon, dans l'orifice A2. Après insertion de la partie en saillie B2 dans l'orifice A2, une face du deuxième plateau B1 du bouchon B vient contre une face du premier plateau A1 du socle A. Ainsi, le socle A permet la compression du deuxième plateau B1 du bouchon B grâce au couvercle 16 ; une fois le bouchon B inséré dans le socle A, la partie en saillie B2 du bouchon est ainsi comprimée dans l'orifice A2 du socle A.

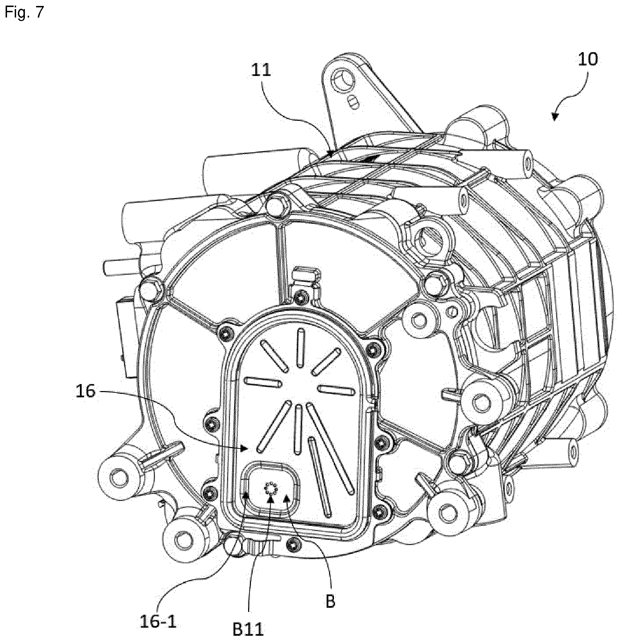

En référence à la figure 7, le couvercle 16 de I `équipement électrique 10 permet de recouvrir le deuxième logement 12B de manière étanche au moyen d'un joint d'étanchéité (non représenté) disposé entre le palier 12 et le couvercle 16 de l'équipement électrique 10, notamment sur la périphérie du couvercle 16.

Le couvercle 16 comprend également une ouverture 16-1 traversante, dont les bords sont configurés pour venir en appui sur le deuxième plateau B1 du bouchon B, notamment à la périphérie du deuxième plateau B1, et ainsi assurer l'étanchéité au niveau de l'ouverture 16-1. Une portion dudit couvercle 16 vient ainsi en appui sur ledit plateau B1 du bouchon B contre une ligne fermée décrivant la périphérie dudit plateau B1 du bouchon B.

Le bouchon B étant constitué d'un matériau plus souple que le socle A, l'appui du couvercle 16 sur le deuxième plateau B1 du bouchon B assure une mise en compression du deuxième plateau B1 du bouchon B entre les bords de l'ouverture 16-1 et le premier plateau A1 du socle A, et par conséquent une étanchéité au niveau du passage du fil électrique 13. Contrairement à l'art antérieur, le contact entre le couvercle 16 et le palier 12 est uniforme, ce qui améliore l'étanchéité.

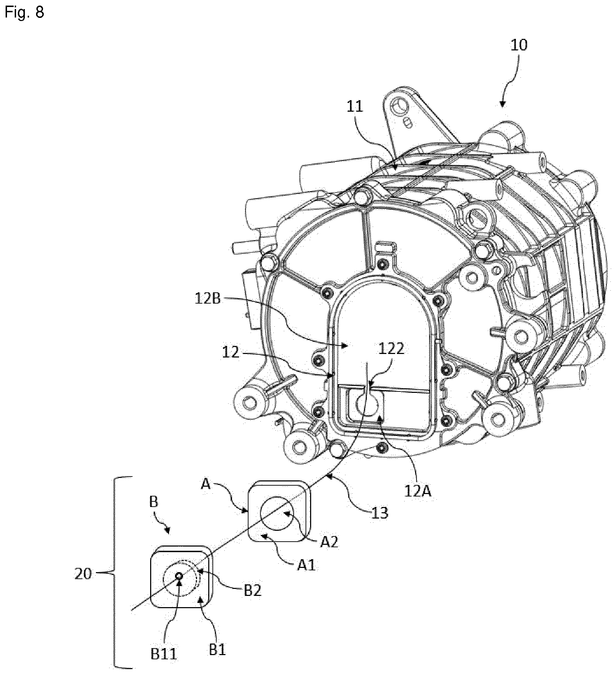

En référence à la figure 8, il est représenté l'équipement électrique 10 ainsi qu'un système d'étanchéité 20, permettant de décrire un procédé d'étanchéification d'un équipement électrique 10 ; à cette fin, un système d'étanchéité 20 est fixé sur l'équipement électrique 10, conformément à un premier mode de réalisation de l'invention.

Dans une première étape d'un procédé d'étanchéification selon l'invention, la partie en saillie B2 du bouchon B est insérée dans l'orifice A2 du socle A. Ainsi, le bouchon B et le socle A constituent un ensemble dont les parties sont solidaires l'une de l'autre.

Dans une deuxième étape, chaque fil électrique 13 est inséré dans un trou B11 traversant le bouchon B. La première et la deuxième étape pouvant être inversées.

Enfin, dans une troisième étape, l'ensemble formé par le bouchon B, le socle A et le ou les fils électriques 13, est inséré dans le premier logement 12A du palier 12, de sorte que le socle A soit inséré au fond dudit premier logement 12A et de sorte que le ou les fils électriques 13 accèdent à l'intérieur de l'équipement électrique 10, notamment au deuxième logement 12B en passant par l'encoche 122 du palier 12. L'assemblage entre ces différents éléments est donc simple et rapide.

Enfin, dans une quatrième étape, le couvercle 16 est fixé par-dessus cet ensemble et la compression du deuxième plateau B1, placé entre le couvercle 16 et le socle A, permet d'étanchéifier l'équipement électrique 10 au niveau de la connexion électrique de l'équipement électrique 10.

Cet assemblage permet en outre d'assurer une double étanchéité au niveau de la connexion électrique de l'équipement électrique 10. Tout d'abord, l'insertion de chaque fil électrique 13 dans un trou B11 permet d'assurer l'étanchéité des fils électriques 13. D'autre part, l'étanchéité est aussi assurée par la compression des bords de l'ouverture 16-1 du couvercle 16 sur la partie externe du deuxième plateau B1 du bouchon B contre le socle A, lui-même inséré dans le premier logement 12A.

Ainsi, la présente invention permet un découplage entre l'étanchéité du passage des fils électriques 13 à travers le bouchon B et celle de l'équipement électrique 10.

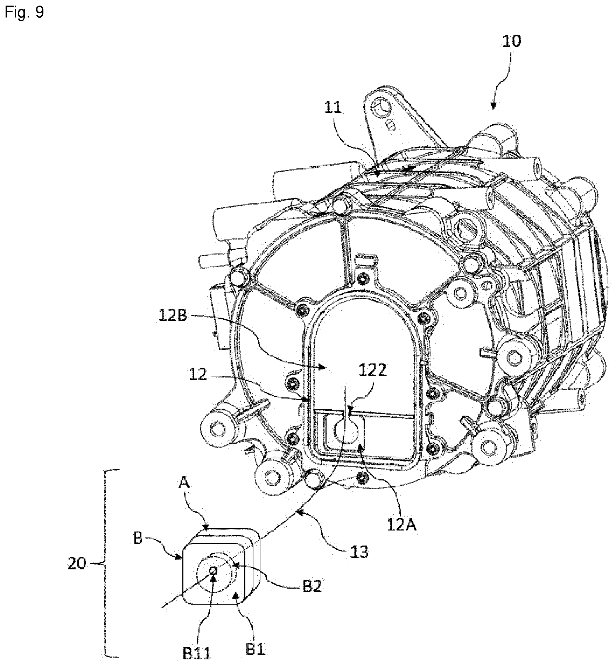

En référence à la figure 9, il est représenté une deuxième forme de réalisation dans laquelle le socle A est surmoulé sur le bouchon B, avec lequel il forme un ensemble monobloc, c'est-à-dire d'un seul tenant solidaire. Le socle A peut être également surmoulé ou non avec le fil électrique 13. Le premier logement 12A peut présenter une encoche 122, comme dans la première forme de réalisation. Le procédé d'étanchéification de la deuxième forme de réalisation du système d'étanchéité 20 comprend la deuxième, troisième et quatrième étape du procédé d'étanchéification du premier mode de réalisation.

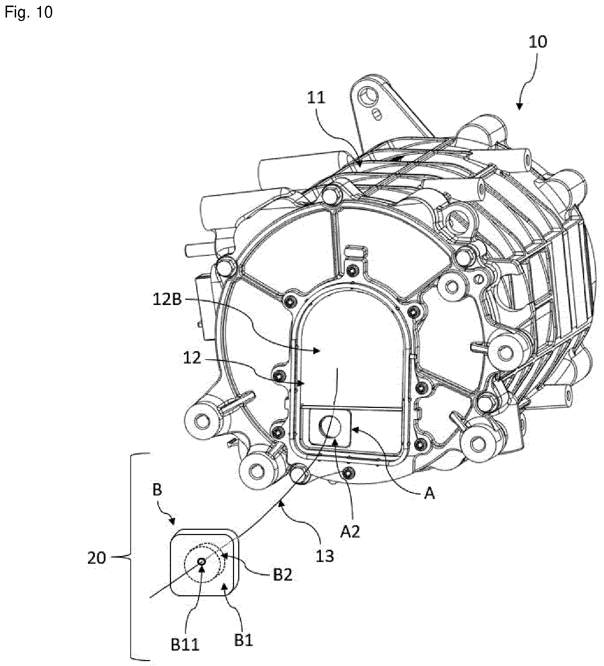

En référence à la figure 10, il est représenté une troisième forme de réalisation. Selon cette forme de réalisation, le socle A est issu de matière du palier 12. Autrement dit, le socle A est formé par un fond du premier logement 12A. En particulier, le palier 12 ne présente pas d'encoche 122 comme dans la première forme de réalisation. Selon cette troisième forme de réalisation, le procédé d'étanchéité comprend une première étape lors de laquelle la partie en saillie B2 du bouchon B est insérée dans l'orifice A2 du socle A et une deuxième étape lors de laquelle le couvercle 16 est fixé par-dessus le palier 12.

## Revendications

1. Système d'étanchéité (20) configuré pour permettre la réalisation d'une connexion électrique étanche sur une face d'un équipement électrique (10), ledit système d'étanchéité (20) comprenant :
un socle (A), comprenant un premier plateau (A1), ledit premier plateau (A1) comprenant un orifice (A2) traversant, tout le bord de l'orifice (A2) traversant étant continument compris dans une face dudit premier plateau (A1),
un bouchon (B) comprenant un deuxième plateau (B1) et une partie en saillie (B2) depuis ledit plateau (B1) du bouchon (B), ladite partie en saillie (B2) étant adaptée pour s'insérer dans l'orifice (A2) du socle (A), une face du deuxième plateau (B1) du bouchon (B) venant contre une face du premier plateau (A1) du socle (A), le deuxième plateau (B1) et la partie en saillie (B2) comprenant au moins un trou (B11) traversant, destiné à permettre le passage d'au moins un fil électrique (13), l'au moins un trou (B11) ayant une section inférieure à celle de l'au moins un fil électrique (13),
ledit bouchon (B) présentant une souplesse supérieure à la souplesse du socle (A), de sorte que, lorsque le système d'étanchéité (20) est positionné sur une face de l'équipement électrique (10) et lors d'une mise en appui du plateau du bouchon (B) sur le plateau du socle (A), la différence de souplesse permet une mise en contrainte du deuxième plateau (B1) du bouchon (B) sur le premier plateau (A1) du socle (A), de manière à assurer une compression du deuxième plateau (B1) du bouchon (B) participant à l'étanchéité de l'équipement électrique (10), ladite partie en saillie (B2) du bouchon (B) étant configurée pour être montée en force dans l'orifice (A2) du socle (A) et les dimensions de la partie en saillie (B2) étant égales ou supérieures à celles de l'orifice (A2),
le système d'étanchéité (20) étant configuré pour être inséré dans un premier logement (12A) de dimensions correspondantes aménagé sur la face de l'équipement électrique (10), de sorte qu'un couvercle (16) de l'équipement électrique (10) vienne assurer la mise en appui du deuxième plateau (B1) du bouchon (B) contre le premier plateau (A1) du socle (A).

2. Système d'étanchéité (20) selon la revendication 1, dans lequel ledit socle (A) et ledit bouchon (B) sont des pièces indépendantes.

3. Système d'étanchéité (20) selon l'une des revendications précédentes, dans lequel le socle (A) et le bouchon (B) forment un ensemble indépendant configuré pour être rapporté sur un châssis de l'équipement électrique (10).

4. Equipement électrique (10), comprenant un système d'étanchéité selon l'une des revendications précédentes, ainsi qu'un couvercle (16) rapporté sur ladite face de l'équipement électrique (10) de façon à fermer au moins en partie ledit équipement électrique (10), une portion dudit couvercle (16) venant assurer la mise en appui sur ledit deuxième plateau (B1) du bouchon (B) au moins contre une ligne fermée décrivant la périphérie dudit deuxième plateau (B1) du bouchon (B).

5. Equipement électrique (10) selon la revendication précédente, dans lequel ledit couvercle (16) comprend une ouverture (16-1) traversante, dont les bords viennent continûment au moins contre ladite ligne fermée décrivant la périphérie dudit deuxième plateau (B1) du bouchon (B), de manière à entourer ledit au moins un trou (B11) du deuxième plateau (B1) du bouchon (B).

6. Equipement électrique (10) selon l'une des revendications 4 à 5, comprenant un palier (12) formant une partie de châssis dudit équipement électrique (10), ledit palier (12) présentant un premier logement (12A) contenant ledit système d'étanchéité (20).

7. Equipement électrique selon la revendication précédente, dans lequel le socle (A) est une pièce différente du palier (12) et est rapporté dans le premier logement (12A).

8. Equipement électrique selon la revendication précédente, dans lequel une paroi périphérique dudit premier logement (12A) présente une encoche (122) s'étendant depuis une ouverture du premier logement (12A) par laquelle le bouchon (B) est reçu dans ledit premier logement (12A), ladite encoche (122) étant configurée pour permettre le passage de l'au moins un fil électrique (13) vers l'intérieur de l'équipement électrique (10) lors d'un montage du bouchon (B) dans ledit premier logement (12A).

9. Equipement électrique (10) selon la revendication 6, comprenant un système d'étanchéité (20) selon l'une des revendications 1 à 2, dans lequel le socle (A) est solidaire du palier (12) ou est venu de matière avec le palier (12).

10. Equipement électrique (10) selon la revendication précédente, dans lequel le socle (A) est compris dans un fond du premier logement (12A) recevant le bouchon (B).

11. Equipement électrique (10) selon la revendication 6, comprenant un système d'étanchéité (20) selon la revendication 3.

12. Procédé d'étanchéification d'un équipement électrique (10) selon l'une des revendications 6 à 11, ledit procédé étant destiné à rendre étanche une cavité (11) aménagée dans un palier (12) formant une partie de châssis dudit équipement électrique (10), le procédé comprenant des étapes :
d'insertion de la partie en saillie (B2) du bouchon (B) dans l'orifice (A2) du socle (A),
d'insertion de chaque câble (13) du faisceau de câbles (13) dans un trou (B11) du bouchon (B),
d'insertion de l'ensemble comprenant le bouchon (B), le socle (A) et le faisceau de câbles (13) dans le premier logement (12A) du palier (12),
de fixation du couvercle (16) sur le palier (12) de sorte que les bords de l'ouverture (16-1) traversante du couvercle (16) sont en appui sur le deuxième plateau (B1) du bouchon (B).

## Patentansprüche

1. Abdichtsystem (20), welches dafür ausgelegt ist, die Herstellung einer dichten elektrischen Verbindung auf einer Seite eines elektrischen Gerätes (10) zu ermöglichen, wobei das Abdichtsystem (20) umfasst:
einen Sockel (A), der eine erste Platte (A1) umfasst, wobei die erste Platte (A1) eine durchgehende Bohrung (A2) umfasst, wobei der gesamte Rand der durchgehenden Bohrung (A2) vollständig in einer Seite der ersten Platte (A1) enthalten ist,
einen Stopfen (B), der eine zweite Platte (B1) und einen von der Platte (B1) des Stopfens (B) vorstehenden Teil (B2) umfasst, wobei der vorstehende Teil (B2) so gestaltet ist, dass er in die Bohrung (A2) des Sockels (A) passt, wobei eine Seite der zweiten Platte (B1) des Stopfens (B) an einer Seite der ersten Platte (A1) des Sockels (A) zur Anlage kommt, wobei die zweite Platte (B1) und der vorstehende Teil (B2) wenigstens ein durchgehendes Loch (B11) umfassen, das dazu bestimmt ist, die Durchführung wenigstens eines elektrischen Kabels (13) zu ermöglichen, wobei das wenigstens eine Loch (B11) einen Querschnitt aufweist, der kleiner als derjenige des wenigstens einen elektrischen Kabels (13) ist,
wobei der Stopfen (B) eine Nachgiebigkeit aufweist, die größer als die Nachgiebigkeit des Sockels (A) ist, so dass, wenn das Abdichtsystem (20) auf einer Seite des elektrischen Gerätes (10) positioniert wird und ein Anlegen der Platte des Stopfens (B) an die Platte des Sockels (A) erfolgt, der Unterschied in der Nachgiebigkeit eine Spannungsbeaufschlagung der zweiten Platte (B1) des Stopfens (B) auf der ersten Platte (A1) des Sockels (A) ermöglicht, um ein Zusammendrücken der zweiten Platte (B1) des Stopfens (B) sicherzustellen, das zur Dichtigkeit des elektrischen Gerätes (10) beiträgt, wobei der vorstehende Teil (B2) des Stopfens (B) dafür ausgelegt ist, unter Kraftaufwand in der Bohrung (A2) des Sockels (A) angebracht zu werden, und die Abmessungen des vorstehenden Teils (B2) gleich denjenigen oder größer als diejenigen der Bohrung (A2) sind,
wobei das Abdichtsystem (20) dafür ausgelegt ist, in eine erste Aufnahme (12A) mit entsprechenden Abmessungen eingesetzt zu werden, die an der Seite des elektrischen Gerätes (10) angeordnet ist, so dass eine Abdeckung (16) des elektrischen Gerätes (10) dann die Anlage der zweiten Platte (B1) des Stopfens (B) an der ersten Platte (A1) des Sockels (A) sicherstellt.

2. Abdichtsystem (20) nach Anspruch 1, wobei der Sockel (A) und der Stopfen (B) unabhängige Teile sind.

3. Abdichtsystem (20) nach einem der vorhergehenden Ansprüche, wobei der Sockel (A) und der Stopfen (B) eine unabhängige Baugruppe bilden, die dafür ausgelegt ist, an einen Rahmen des elektrischen Gerätes (10) angesetzt zu werden.

4. Elektrisches Gerät (10), welches ein Abdichtsystem nach einem der vorhergehenden Ansprüche sowie eine Abdeckung (16), die an die Seite des elektrischen Gerätes (10) so angesetzt ist, dass sie das elektrische Gerät (10) wenigstens teilweise verschließt, umfasst, wobei ein Abschnitt der Abdeckung (16) die Anlage an der zweiten Platte (B1) des Stopfens (B) wenigstens an einer geschlossenen Linie sicherstellt, die den Umfang der zweiten Platte (B1) des Stopfens (B) beschreibt.

5. Elektrisches Gerät (10) nach dem vorhergehenden Anspruch, wobei die Abdeckung (16) eine durchgehende Öffnung (16-1) umfasst, deren Ränder durchgehend wenigstens an der geschlossenen Linie zur Anlage kommen, die den Umfang der zweiten Platte (B1) des Stopfens (B) beschreibt, so dass sie das wenigstens eine Loch (B11) der zweiten Platte (B1) des Stopfens (B) umgeben.

6. Elektrisches Gerät (10) nach einem der Ansprüche 4 bis 5, welches ein Lager (12) umfasst, das einen Teil des Rahmens des elektrischen Gerätes (10) bildet, wobei das Lager (12) eine erste Aufnahme (12A) aufweist, die das Abdichtsystem (20) enthält.

7. Elektrisches Gerät nach dem vorhergehenden Anspruch, wobei der Sockel (A) ein von dem Lager (12) verschiedenes Teil ist und in der ersten Aufnahme (12A) angebracht ist.

8. Elektrisches Gerät nach dem vorhergehenden Anspruch, wobei eine Umfangswand der ersten Aufnahme (12A) eine Aussparung (122) aufweist, die sich von einer Öffnung der ersten Aufnahme (12A) aus erstreckt, durch welche der Stopfen (B) in der ersten Aufnahme (12A) aufgenommen wird, wobei die Aussparung (122) dafür ausgelegt ist, bei einer Anbringung des Stopfens (B) in der ersten Aufnahme (12A) die Durchführung des wenigstens einen elektrischen Kabels (13) ins Innere des elektrischen Gerätes (10) zu ermöglichen.

9. Elektrisches Gerät (10) nach Anspruch 6, welches ein Abdichtsystem (20) nach einem der Ansprüche 1 bis 2 umfasst, wobei der Sockel (A) mit dem Lager (12) fest verbunden ist oder mit dem Lager (12) stoffschlüssig verbunden ist.

10. Elektrisches Gerät (10) nach dem vorhergehenden Anspruch, wobei der Sockel (A) in einem Boden der ersten Aufnahme (12A) enthalten ist, die den Stopfen (B) aufnimmt.

11. Elektrisches Gerät (10) nach Anspruch 6, welches ein Abdichtsystem (20) nach Anspruch 3 umfasst.

12. Verfahren zur Abdichtung eines elektrischen Gerätes (10) nach einem der Ansprüche 6 bis 11, wobei das Verfahren dazu bestimmt ist, einen Hohlraum (11) abzudichten, der in einem Lager (12) angeordnet ist, das einen Teil des Rahmens des elektrischen Gerätes (10) bildet, wobei das Verfahren Schritte umfasst:
des Einsetzens des vorstehenden Teils (B2) des Stopfens (B) in die Bohrung (A2) des Sockels (A),
des Einsetzens jedes Kabels (13) des Kabelbaums (13) in ein Loch (B11) des Stopfens (B),
des Einsetzens der Baugruppe, die den Stopfen (B), den Sockel (A) und den Kabelbaum (13) umfasst, in die erste Aufnahme (12A) des Lagers (12),
der Befestigung der Abdeckung (16) auf dem Lager (12), so dass die Ränder der durchgehenden Öffnung (16-1) der Abdeckung (16) an der zweiten Platte (B1) des Stopfens (B) anliegen.

## Claims

1. Sealing system (20) configured to allow the realization of a sealed electrical connection on a face of an item of electrical equipment (10), said sealing system (20) comprising:
a base (A) comprising a first plate (A1), said first plate (A1) comprising a through-orifice (A2), the entire edge of the through-orifice (A2) being continuously comprised in a face of said first plate (A1),
a stopper (B) comprising a second plate (B1) and a protruding part (B2) protruding from said plate (B1) of the stopper (B), said protruding part (B2) being designed to be inserted in the orifice (A2) of the base (A), a face of the second plate (B1) of the stopper (B) coming into contact with a face of the first plate (A1) of the base (A), the second plate (B1) and the protruding part (B2) comprising at least one through-hole (B11) which is intended to allow at least one electrical wire (13) to pass through, the at least one hole (B11) having a cross section smaller than that of the at least one electrical wire (13),
said stopper (B) having a greater flexibility than the flexibility of the base (A), such that, when the sealing system (20) is positioned on a face of the item of electrical equipment (10) and when the plate of the stopper (B) butts against the plate of the base (A), the difference in flexibility allows the second plate (B1) of the stopper (B) to be stressed against the first plate (A1) of the base (A), so as to ensure a compression of the second plate (B1) of the stopper (B) contributing to the sealing of the item of electrical equipment (10), said protruding part (B2) of the stopper (B) being configured to be force-fitted in the orifice (A2) of the base (A) and the dimensions of the protruding part (B2) being equal to or greater than those of the orifice (A2),
the sealing system (20) being configured to be inserted in a first cutout (12A) of corresponding dimensions provided in the face of the item of electrical equipment (10), such that a cover (16) of the item of electrical equipment (10) ensures that the second plate (B1) of the stopper (B) butts against the first plate (A1) of the base (A).

2. Sealing system (20) according to Claim 1, wherein said base (A) and said stopper (B) are independent components.

3. Sealing system (20) according to either of the preceding claims, wherein the base (A) and the stopper (B) form an independent assembly configured to be attached to a frame of the item of electrical equipment (10).

4. Item of electrical equipment (10) comprising a sealing system according to one of the preceding claims, and also a cover (16) attached to said face of the item of electrical equipment (10) so as to at least partially close said item of electrical equipment (10), a portion of said cover (16) serving for abutment against said second plate (B1) of the stopper (B), at least against a closed line describing the periphery of said second plate (B1) of the stopper (B).

5. Item of electrical equipment (10) according to the preceding claim, wherein said cover (16) comprises a through-opening (16-1), the edges of which come into continuous contact at least with said closed line describing the periphery of said second plate (B1) of the stopper (B), so as to surround said at least one hole (B11) of the second plate (B1) of the stopper (B).

6. Item of electrical equipment (10) according to either one of Claims 4 and 5, comprising a bearing (12) forming a frame part of said item of electrical equipment (10), said bearing (12) having a first cutout (12A) containing said sealing system (20).

7. Item of electrical equipment according to the preceding claim, wherein the base (A) is a component separate from the bearing (12) and is attached in the first cutout (12A).

8. Item of electrical equipment according to the preceding claim, wherein a peripheral wall of said first cutout (12A) has a slot (122) extending from an opening in the first cutout (12A), the stopper (B) being received in said first cutout (12A) through said opening, said slot (122) being configured to allow the at least one electrical wire (13) to pass through towards the interior of the item of electrical equipment (10) when the stopper (B) is fitted in said first cutout (12A).

9. Item of electrical equipment (10) according to Claim 6, comprising a sealing system (20) according to either of Claims 1 and 2, wherein the base (A) is secured to the bearing (12) or is formed in one piece with the bearing (12).

10. Item of electrical equipment (10) according to the preceding claim, wherein the base (A) is comprised in a bottom of the first cutout (12A) receiving the stopper (B).

11. Item of electrical equipment (10) according to Claim 6, comprising a sealing system (20) according to Claim 3.

12. Method for sealing an item of electrical equipment (10) according to one of Claims 6 to 11, said method being intended to seal a cavity (11) provided in a bearing (12) forming a frame part of said item of electrical equipment (10), the method comprising the following steps:
inserting the protruding part (B2) of the stopper (B) in the orifice (A2) of the base (A),
inserting each cable (13) of the bundle of cables (13) in a hole (B11) of the stopper (B),
inserting the assembly comprising the stopper (B), the base (A) and the bundle of cables (13) in the first cutout (12A) of the bearing (12),
fastening the cover (16) to the bearing (12) such that the edges of the through-opening (16-1) of the cover (16) butt against the second plate (B1) of the stopper (B).
